# EUROPEAN PATENT APPLICATION

(11) **EP 4 827 313 A2**
(43) Date of publication of application: **21.10.2026**
(21) Application number: 26164883.6
(22) Date of filing: 16.03.2026
(51) Int. Cl.: H10W 90/10, H10W 90/20, H10W 72/20

(54) **VOLTAGE REGULATORS FOR EFFICIENT POWER DELIVERY**

(30) Priority: 28.03.2025 US 202519094223
(71) Applicant: Altera Corporation, San Jose, CA 95134 (US)
(72) Inventor: KOLLURA, Krishna Bharath, Hillsboro, OR97124 (US); HOSSAIN, Md Altaf, Portland, OR 97229 (US)
(74) Representative: Hermann, Felix

(57) **Abstract**

Systems or methods of the present disclosure may provide a voltage regulator design for efficient power delivery. The present disclosure includes one or more integrated circuits with one or more sectors of programmable logic circuitry and one or more voltage regulators. The present disclosure also includes a first set of layers on a front plane of a programmable logic device and a second set of layers formed using backside metallization on a back plane of the programmable logic device.

## Description

### BACKGROUND

The present disclosure relates generally to integrated circuits, such field-programmable gate arrays (FPGAs). More particularly, the present disclosure relates to implementing voltage regulators within programmable logic circuitry of an integrated circuit.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Integrated circuit devices (e.g., multi-chip packages) may be utilized for a variety of purposes or applications. To power the integrated circuit devices, for example, some processors (e.g., multi-core processors) may include voltage regulators that provide power to one or more processor cores of the processor. In contrast, programmable logic devices, a class of integrated circuit devices, may include voltage regulators positioned outside of and/or adjacent to the programmable logic devices due to routing density within the programmable logic device. For example, the routing density of the programmable logic devices may limit a number of components that may be positioned within programmable logic of the programmable logic devices. Placing the voltage regulators on a package substrate and communicatively coupling the voltage regulators to the programmable logic devices increases a distance between components of the programmable logic devices and the voltage regulators, which may result in inefficient power delivery to the components.

### BRIEF DESCRIPTION OF THE DRAWINGS

Various aspects of this disclosure may be better understood upon reading the following detailed description and upon reference to the drawings in which:
FIG. 1 is a block diagram of a system used to program an integrated circuit system, in accordance with an embodiment of the present disclosure;
FIG. 2 is a block diagram of the integrated circuit system of FIG. 1, in accordance with an embodiment of the present disclosure;
FIG. 3 is a schematic diagram of an embodiment of the integrated circuit system of FIG. 1 including a voltage regulator positioned within an integrated circuit, in accordance with an embodiment of the present disclosure;
FIG. 4 is a schematic diagram of another embodiment of the integrated circuit system of FIG. 1 with a first integrated circuit and a second integrated circuit stacked on top of the first integrated circuit, in accordance with an embodiment of the present disclosure;
FIG. 5 is a schematic diagram of an embodiment of an integrated circuit including voltage regulators of FIG. 3 positioned in a column, in accordance with an embodiment of the present disclosure;
FIG. 6 is a schematic diagram of another embodiment of an integrated circuit including voltage regulators FIG. 3 positioned in with two columns, in accordance with an embodiment of the present disclosure;
FIG. 7 is a flowchart of a method for manufacturing the integrated circuit system of FIG. 1, in accordance with an embodiment of the present disclosure; and
FIG. 8 is a block diagram of a data processing system including the integrated circuit system of FIG. 1, in accordance with an embodiment of the present disclosure.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the phrase A "based on" B is intended to mean that A is at least partially based on B. Moreover, the term "or" is intended to be inclusive (e.g., logical OR) and not exclusive (e.g., logical XOR). In other words, the phrase A "or" B is intended to mean A, B, or both A and B.

The present disclosure describes systems and techniques related to implementing voltage regulators within field programmable gate arrays (FPGAs) to improve power delivery. For example, the embodiments described herein are directed to forming routing circuitry within a first set of layers (e.g., frontside metal layers) of the FPGA and power delivery circuitry within a second set of layers (e.g., backside metal layers) of the FPGA. In this way, the first set of layers may prioritize signal transfers, and the second set of layers may distribute power within the FPGA. The FPGA may include at least one voltage regulator positioned within the FPGA to deliver power to the power delivery circuitry of the second set of layers. In this way, the FPGA may utilize backside power delivery (e.g., via the second set of layers). By segregating signal routing on the first set of metal layers and power routing on the second set of metal layers, the FPGA may implement an efficient power delivery architecture via the backside power delivery.

The embodiments described herein implement voltage regulators (e.g., fully integrated voltage regulator (FIVR), a capacitor-coupled voltage regulator (C2VR)) within programmable logic of FPGAs to implement the power delivery architecture. The voltage regulator may be positioned with the programmable logic to deliver power to the programmable logic and/or one or more components within the programmable logic. For example, an input of the voltage regulator may couple to a bump via a pathway through the second set of layers to receive power via the bump, and an output of the voltage regulator may provide power to a sector (e.g., region) of programmable logic. By positioning the voltage regulator within programmable logic of the FPGA, a distance for power delivery decreases, which may reduce power loss and improve power delivery. In addition, using backside power delivery may reduce and/or eliminate interference between power delivery circuitry formed in the second set of layers and routing resources (e.g., routing circuitry) formed in the first set of layers. For example, the routing resources may provide signal transfer between at least the components of the FPGA, between two or more FPGAs, between the FPGA and off-package components, or any combination thereof.

The voltage regulators may utilize various combinations of designs (e.g., FIVR and C2VR). For example, a top die (e.g., a first die) and a bottom die (e.g., a second die) of multi-die package may include be C2VRs positioned within programmable logic of the top die and bottom die, respectively. In another example, the top die and the bottom die may include FIVRs positioned within programmable logic of the top die and bottom die, respectively. To include the FIVRs, the multi-die package may include an inductor in a package substrate of the multi-die package. In other examples, the top die may include FIVRs and the bottom die may include C2VRs, or vice versa.

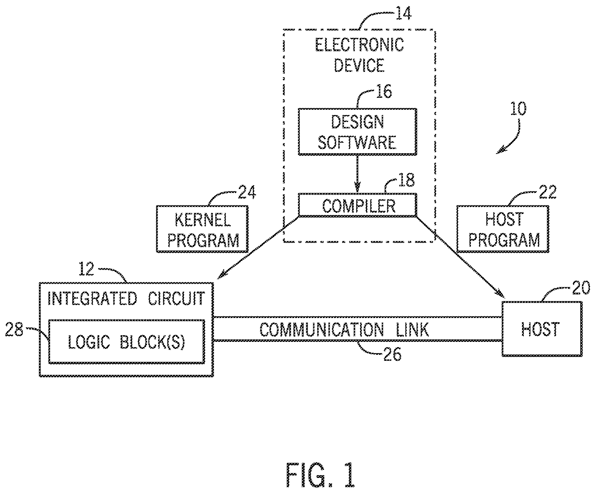

With the foregoing in mind, FIG. 1 illustrates a block diagram of a system 10 that may be used to implement voltage regulators within programmable logic and/or a backside power delivery technique described in this disclosure on an integrated circuit system 12 (e.g., a single monolithic integrated circuit or a multi-die system of integrated circuits). The integrated circuit system 12 may include a single integrated circuit, multiple integrated circuits in a package, or multiple integrated circuits in multiple packages communicating remotely (e.g., via wires or traces). In some cases, the designer may specify a high-level program to be implemented, such as an OPENCL^{®} program that may enable the designer to more efficiently and easily provide programming instructions to configure a set of programmable logic cells for the integrated circuit system 12 without specific knowledge of low-level hardware description languages (e.g., Verilog, very high-speed integrated circuit hardware description language (VHDL)). For example, since OPENCL^{®} is quite similar to other high-level programming languages, such as C++, designers of programmable logic familiar with such programming languages may have a reduced learning curve than designers that are required to learn unfamiliar low-level hardware description languages to implement new functionalities in the integrated circuit system 12.

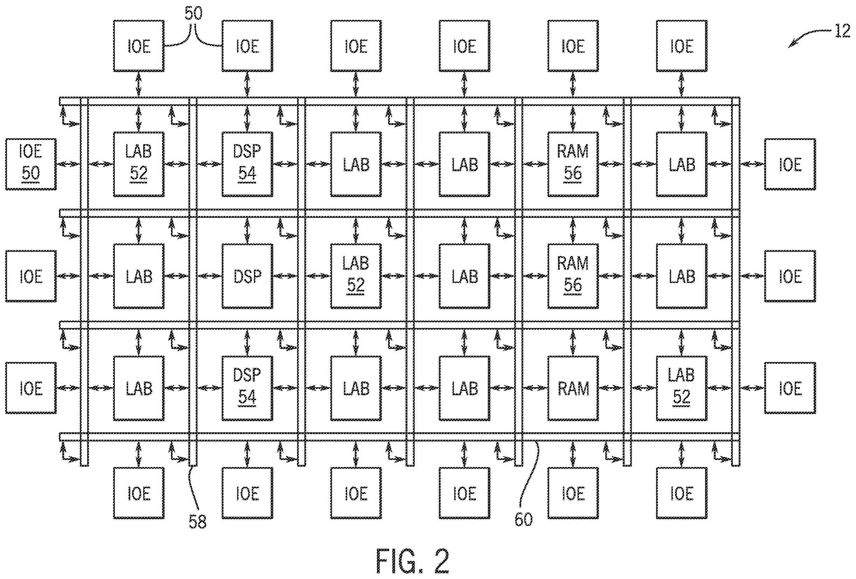

The integrated circuit system 12 may include a field-programmable gate array (FPGA). In a configuration mode of the integrated circuit system 12, a designer may use an electronic device 14 (e.g., a computer) to implement high-level designs (e.g., a system user design) using design software 16, such as a version of INTEL^{®} QUARTUS^{®} by INTEL CORPORATION. The electronic device 14 may use the design software 16 and a compiler 18 to convert the high-level program into a lower-level description (e.g., a configuration program, a bitstream). The compiler 18 may provide machine-readable instructions representative of the high-level program to a host 20 and the integrated circuit system 12. The host 20 may receive a host program 22 that may control or be implemented by a kernel program 24. To implement the host program 22, the host 20 may communicate instructions from the host program 22 to the integrated circuit system 12 via a communication link 26 that may include, for example, direct memory access (DMA) communications or peripheral component interconnect express (PCIe) communications. As will be described in greater detail below in FIG. 2, in some embodiments, the kernel program 24 and the host 20 may enable configuration of a logic block 28 on the integrated circuit system 12. The logic block 28 may include circuitry and/or other logic elements and may be configurable to implement a variety of functions in combination with digital signal processing (DSP) blocks.

The designer may use the design software 16 to generate and/or to specify a low-level program, such as the low-level hardware description languages described above. Further, in some embodiments, the system 10 may be implemented without the host program 22. Thus, embodiments described herein are intended to be illustrative and not limiting.

An illustrative embodiment of the integrated circuit system 12 such as a programmable logic device (PLD) that may be configured to implement a circuit design is shown in FIG. 2. As illustrated in FIG. 2, the integrated circuit system 12 (e.g., an FPGA) may include a 2-dimensional array of functional blocks, including programmable logic blocks 52 (also referred to as logic array blocks (LABs) or configurable logic blocks (CLBs)) and other functional blocks, such as embedded digital signal processing (DSP) blocks 54 and embedded random-access memory (RAM) blocks 56, for example. Functional blocks such as LABs 52 may include smaller programmable regions (e.g., logic elements, configurable logic blocks, or adaptive logic modules) that receive input signals and perform custom functions on the input signals to produce output signals. LABs 52 may also be grouped into larger programmable regions sometimes referred to as logic sectors that are individually managed and configured by corresponding logic sector managers. The grouping of the programmable logic resources on the integrated circuit system 12 into logic sectors, logic array blocks, logic elements, or adaptive logic modules is merely illustrative. In general, the integrated circuit system 12 may include functional logic blocks of any suitable size and type, which may be organized in accordance with any suitable logic resource hierarchy.

Programmable logic in the integrated circuit system 12 may contain programmable memory elements. Memory elements may be loaded with configuration data (also called programming data or configuration bitstream) using input-output elements (IOEs) 50. Once loaded, the memory elements each provide a corresponding static control signal that controls the operation of an associated functional block (e.g., LABs 52, DSP 54, RAM 56, or IOEs 50).

In one scenario, the outputs of the loaded memory elements are applied to the gates of metal-oxide-semiconductor transistors in a functional block to turn certain transistors on or off and thereby configure the logic in the functional block including the routing paths. Programmable logic circuit elements that may be controlled in this way include parts of multiplexers (e.g., multiplexers used for forming routing paths in interconnect circuits), lookup tables, logic arrays, AND, OR, NAND, and NOR logic gates, pass gates, etc.

The memory elements may use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory, configuration random-access memory (CRAM), or programmable memory elements.

In addition, the programmable logic device may have IOEs 50 for driving signals off the integrated circuit system 12 and for receiving signals from other devices. The IOEs 50 may include parallel input-output circuitry, serial data transceiver circuitry, differential receiver and transmitter circuitry, or other circuitry used to connect one integrated circuit to another integrated circuit. The integrated circuit system 12 may also include programmable interconnect circuitry in the form of vertical routing channels 58 (e.g., interconnects formed along a vertical axis of the integrated circuit system 12) and horizontal routing channels 60 (e.g., interconnects formed along a horizontal axis of the integrated circuit system 12), each routing channel including at least one track to route at least one wire. If desired, the interconnect circuitry may include pipeline elements, and the contents stored in these pipeline elements may be accessed during operation. For example, a programming circuit may provide read and write access to a pipeline element.

The integrated circuit system 12 may be configured to implement a custom circuit design. For example, the configuration RAM may be programmed such that LABs 52, DSP 54, and RAM 56, programmable interconnect circuitry (e.g., vertical routing channels 58 and horizontal routing channels 60), and the IOEs 50 form the circuit design implementation.

Note that other routing topologies, besides the topology of the interconnect circuitry depicted in FIG. 2, are intended to be included within the scope of the present invention. For example, the routing topology may include wires that travel diagonally or that travel horizontally and vertically along different parts of their extent as well as wires that are perpendicular to the device plane in the case of 3-dimensional integrated circuits, and the driver of a wire may be located at a different point than one end of a wire. The routing topology may include global wires that span substantially all of the integrated circuit system 12, fractional global wires such as wires that span part of the integrated circuit system 12, staggered wires of a particular length, smaller local wires, or any other suitable interconnection resource arrangement.

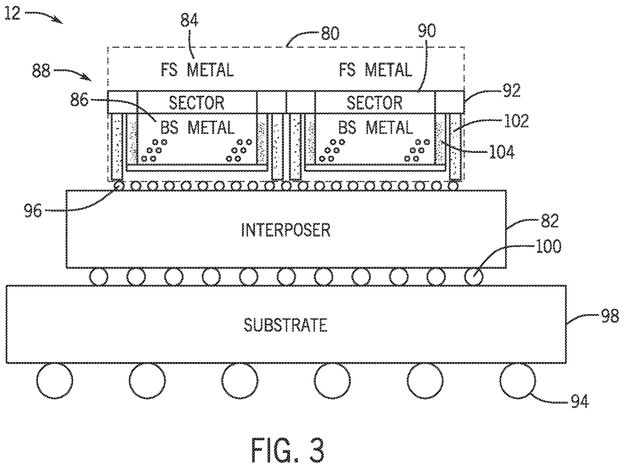

FIG. 3 is a schematic diagram of an embodiment of the integrated circuit system 12 with an integrated circuit 80 coupled to package substrate 98 via an interposer 82. The schematic diagram of FIG. 3 illustrates a cross-sectional view of the integrated circuit 80 implementing voltage regulators in programmable logic of the integrated circuit 80 and/or the backside power delivery technique described herein.

The integrated circuit 80 may be mounted on an interposer. The interposer 82 may include an active interposer, a passive interposer, a bridge (e.g., an embedded multi-die interconnect bridge (EMIB)), or any combination thereof. The interposer 82 may facilitate signal transfer and power delivery between one or more integrated circuits coupled to the interposer 82 and/or between the one or more integrated circuits and one or more components coupled to the interposer 82. In other examples, the integrated circuit 80 may be coupled to one or more additional integrated circuits via the interposer 82 in a 2.5-dimensional (2.5D) form. Additionally or alternatively, the integrated circuit system 12 may include additional integrated circuits in a 3-dimensional (3D) form.

The integrated circuit 80 may couple to the interposer 82 via one or more microbumps 96. Although microbumps 96 are discussed throughout, any bonding techniques that are suitable for coupling the integrated circuit 80 to the interposer 82 may be used. For example, the integrated circuit 80 may be coupled to the interposer 82 via high bandwidth interfaces (e.g., 2.5D interfaces, interconnect bridges, microbump interfaces) and/or any other suitable multichannel interconnect. The microbumps 96 may couple to an interface of the integrated circuit 80 (e.g., a fabric or FPGA interface and an interface of the interposer 82).

The integrated circuit 80 may be mounted on a package substrate 98 via the interposer 82 and package substrate bumps (PSBs) 100 (e.g., package substrate build-ups, controlled collapse chip connection (C4) bumps). In other examples, the interposer 82 may be partially or fully embedded in the package substrate 98. The PSBs 100 may couple the interposer 82 to the package substrate 98 to provide power and/or signal transfer between the two. The microbumps 96 or hybrid bonds may have any suitable size smaller than the PSBs 100 to enable sufficient communication between dies. Generally, the PSBs 100 (e.g., bumps used for interfacing with off-package components) are substantially larger than in size compared to microbumps 96 (e.g., bumps or bonds used for interfacing with other chips (e.g., chiplets, dies) within the same multi-die package). The number of microbumps 96 is also generally much greater than the number of PSBs 100 (e.g., the ratio of the number of microbumps 96 to the number of PSBs 100 260 may be greater than 2:1, 5:1, 10:1, 100:1, 1000: 1, 10,000:1, 100,000:1, and so forth).

The package substrate 98 may couple to one or more ball grid array (BGA) balls 94. The BGA balls 94 may facilitate signal transfer between components of the integrated circuit system 12 and off-package components, provide power to the integrated circuit system 12, provide grounding between the integrated circuit system 12 and a printed circuit board (PCB) that may be coupled to the BGA balls 94, or any combination thereof.

As discussed herein, the integrated circuit 80 may include a programmable logic device, such as a field programmable gate array (FPGA). The integrated circuit 80 may include frontside metal layers 84 (e.g., first set of layers), backside metal layers 86 (e.g., second set of layers), and a transistor (XTR) plane 88 positioned between the frontside metal layers 84 and the backside metal layers 86. The frontside metal layers 84 and/or backside metal layers 86 may include one or more signal metals dedicated to signal transfer, components for implementing one or more functionalities of the integrated circuit 80, and so on. For example, the backside metal layers 86 may include power delivery circuitry to deliver power components of the integrated circuit 80, and the frontside metal layers 84 may include routing circuitry for signal transfer between the components of the integrated circuit 80 and/or off-package components. As used herein, the term "frontside" may refer to a frontside surface where a conventional integrated circuit may be fabricated, such as a side adjacent to or away from a carrier wafer, and the term "backside" may be an opposite surface of the substrate. Furthermore, the schematic diagram may be a simplified illustration omitting one or more components for the simplicity in discussing the first and second layers.

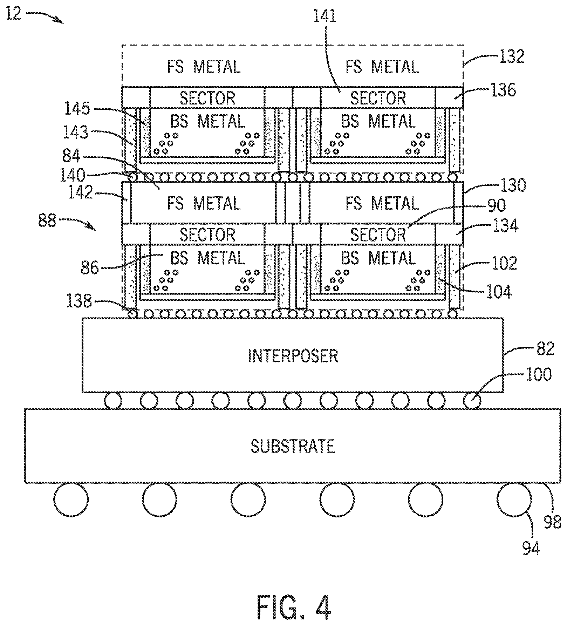

As discussed herein, the integrated circuit 80 may decouple power delivery circuitry from routing circuitry. For example, the frontside metal layers 84 of the integrated circuit 80 may include the routing circuitry, and the backside metal layers 86 the integrated circuit 80 may include power delivery circuitry. The power delivery circuitry may receive power via an input and deliver power within the integrated circuit 80 via an output. As such, the integrated circuit 80 may implement a backside power delivery technique. By positioning the routing circuitry on the frontside metal layers 84 and the power delivery circuitry on the backside metal layers 86, routing density within the backside layers 86 may be reduced, thereby facilitating the addition of voltage regulators within the integrated circuit 80, as illustrated with respect to FIGS. 3 and 4. In another example, interference between the routing circuitry and the power delivery circuitry may be reduced and/or eliminated.

With the foregoing in mind, the XTR plane 88 may connect one or more sectors (e.g., programmable logic sectors, regions, programmable logic regions) 90 and one or more voltage regulators 92. The voltage regulators 92 may include fully integrated voltage regulators (FIVR), a capacitor-coupled voltage regulator (C2VR), or any combination thereof. In the illustrated integrated circuit 80 of FIG. 3, each sector 90 includes two voltage regulators 92. Each sector 90 may be any suitable size and may include any suitable number of components (e.g., IOEs 50, LABs 52, DSP 54 blocks, RAM 56 blocks, transistors). In general, each sector 90 may be individually programmable or controllable by its own respective sector control circuitry; different sectors may be programmed or controlled through different respective sector control circuits. Each sector 90 may include a voltage regulator 92 that provides power to the sector 90. It may be understood that the sectors 90 may encapsulate any suitable number of voltage regulators 92. The number of voltage regulators 92 within each sector 90 may be determined based on attributes (e.g., size, number of components, power consumption, etc.) of the sector 90. For example, a first sector 90 with larger components and/or a higher quantity of components may use more power than a second sector 90 with smaller components and/or a lesser quality of components. As such, the first sector 90 may include larger voltage regulators 90 and/or more voltage regulators 90 to provide power to the first sector 90 in comparison to the second sector 90. Furthermore, as discussed herein, the power provided by each voltage regulator 92 may be adjusted based on power consumption within the sector 90.

The voltage regulator 92 may provide voltage (e.g., power) to a sector 90 of the integrated circuit 80. The voltage regulator 92 may handle different signal types, voltage levels, and/or communication protocols for the sector 90. For example, the voltage regulator 92 may operate at different voltage levels and/or may include voltage scaling features to interface with components of the sector 90 that operate at lower and/or higher voltage domains. The voltage regulator 92 may include an input pathway 102 to receive power via a power ladder from a microbump 96 and an output pathway 104 to provide the power via another ladder to the sector 90. For example, the input 102 of the voltage regulator 92 may be coupled to a microbump 96 to receive power and the output 104 of the voltage regulator may couple to power delivery circuitry within the backside metal layers 86 and/or power delivery circuitry within a sector 90 encapsulating the voltage regulator 92. The power may be delivered to the input 102 of the voltage regulator via a microbump 96, the interposer 82, a PSB 100, the substrate 98, and a BGA ball 94. In other examples, voltage received by the voltage regulator 92 may be at higher voltage levels than voltage levels (e.g., nominal voltage levels) used for components within the sectors 90. Delivering power at higher voltages may use less current, which may decrease an amount of resources consumed by the voltage regulator 92. Additionally, since the distance between the voltage regulators 92 and the power delivery circuitry and/or components of the sector 90 is decreased in comparison to placing voltage regulators 92 outside of the integrated circuit 80, the power delivery length requirements of the BGA balls 94 and/or the PSBs 100 may decrease. For example, placing the voltage regulators 92 within the sectors 90 may decrease an amount of current used to deliver the power to the components within the sector 90. Decreasing the power delivery requirements of the BGA balls 94 and/or the PSBs 100 may decrease a number of BGA balls 94 and/or PSBs 100 used by the integrated circuit system 12 to deliver the power. By reducing the number of BGA balls 94 and/or PSBs 100, a size of the integrated circuit system 12 may decrease. Therefore, power may be delivered more efficiently using the voltage regulator 92.

Routing density within each sector 90 may be determined based on FPGA logic density, such as based on a design implemented on the integrated circuit 80 (e.g., FPGA). The routing density may be considered when creating sectors 90. For example, logic in an array may be repeated between each of the sectors 90, and the sectors 90 may be repeated throughout the integrated circuit 80. Additionally or alternatively, the sectors 90 may be individually accessed. It should be noted that not all sectors 90 may be used to implement the design and/or to perform operations of the integrated circuit 80. As illustrated, each sector 90 may include an independent voltage regulator 92 to provide power to power delivery circuitry and/or components of the sector 90. For example, a each regulator 90 may provide power directly to the sector 90. As further illustrated herein, the integrated circuit 80 may include columns of voltage regulators 92 provide voltage to respective sectors 90. The voltage provided by the voltage regulator 92 may be lower than a maximum voltage level of the sector 90. As such, the voltage regulators 92 may provide an independent power domain to each sector 90. In addition, each sector 90 may be partially located on the frontside metal layers 84 and partially located on the backside metal layers 86.

FIG. 4 is a schematic diagram of another embodiment of the integrated circuit system 12 of FIG. 1 including a first integrated circuit 130 and a second integrated circuit 132 coupled via an microbumps 140. The schematic diagram of FIG. 4 illustrates a cross-sectional view of the first integrated circuit 130 and the second integrated circuit 132, where the first integrated circuit 130 provides power to voltage regulators 136 of the second integrated circuit 132. In the illustrated example, the first integrated circuit 130 and the second integrated circuit 132 are in a 3D form (e.g., stacked configuration). As illustrated, the second integrated circuit 132 may be coupled to the first integrated circuit 130 via a second set of microbumps 140.

As discussed herein, the first integrated circuit 130 may be coupled to the interposer 82 via a first set of microbumps 138. The interposer 82 may couple to the package substrate 98 via PSBs balls 100, and the package substrate 98 may couple to a PCB via BGA balls 94. The PCB may include a voltage regulator that provides power to the voltage regulators 92 at a higher voltage than the voltage regulators 92 may operate at. For example, the voltage regulator in the PCB may provide power to the voltage regulators 92 at a range between 1.5-2.5 Volts (V). The voltage regulators 92 may receive and/or use the power from the voltage regulator in the PCB to generate power at a lower voltage for the sectors 90 in comparison to the power provided by the voltage regulator in the PCB. For example, the voltage regulators 92 may provide the power to the sector 90 at approximately 0.5-1 V. Delivering power at higher voltages may reduce an amount of current used to deliver the power, which may improve power delivery efficiency.

The first integrated circuit 130 may include a first set of voltage regulators 134 and the second integrated circuit 132 may include a second set of voltage regulators 136. The first set of voltage regulators 134 may include the same number of voltage regulators as the second set of voltage regulators 136. In other examples, the first set of voltage regulators 134 may include a different number of voltage regulators than the second set of voltage regulators 136. The second integrated circuit 132 may include at least one voltage regulator 136 positioned within each sector 141 of the second integrated circuit 132. The second set of voltage regulators 136 may each provide power to a sector 141 of the second integrated circuit 132. Each voltage regulator of the second set of voltage regulators 136 may include an input pathway 143 to receive power via a power ladder from a microbump 96 and an output pathway 145 to provide the power via another ladder to the sector 90. The input pathway 143 may be coupled to a microbump of the second set of microbumps 140 to receive power from the first integrated circuit 130. To this end, the first integrated circuit 130 may include through silicon vias (TSVs) 142 formed in the frontside metal layers 84 of the first integrated circuit 130. As such, power may be delivered to each voltage regulator of the second set of voltage regulators 136. In another example, the second integrated circuit 132 may provide power to a hardened processor that may be communicatively coupled to the second integrated circuit 132. For example, the hardened processor may include a component that may not be configurable to implement different designs. For example, the hardened processor may include a pre-designed, fixed-function processor core that may be integrated within the FPGA fabric.

The first set of voltage regulators 134 and the second set of voltage regulators 136 may establish independent power domains within the first integrated circuit 130 and the second integrated circuit 132, respectively. For example, the first set of voltage regulators 134 and/or the second set of voltage regulators 136 may handle different signal types, voltage levels, and/or communication protocols for respective sectors 90, 141. For example, the first set of voltage regulators 134 and the second set of voltage regulators 136 may operate at different voltage levels and/or may include voltage scaling features to interface with components operating at lower and/or higher voltage domains within the respective sectors 90, 141. The power may be delivered to the second set of voltage regulators 136 at higher voltage levels in comparison to voltage levels used by components of the second integrated circuit 132 to improve power delivery and/or reduce an amount of current used for the power delivery. The second set of voltage regulators 136 may perform a step down using the received voltage. Furthermore, the voltage regulators of the first set of voltage regulators 134 and/or the second set of voltage regulators 136 may individually receive power from the voltage regulator in the PCB. The TSVs 142 in the first integrated circuit 130 may communicatively couple the second set of voltage regulators 136 in the second integrated circuit 132 to the BGA balls 94. For example, the first set of voltage regulators 134 in the first integrated circuit 130 and the second set of voltage regulators 136 in the second integrated circuit 132 may receive power from the same BGA ball 94. In another example, the first set of voltage regulators 134 in the first integrated circuit 130 and the second set of voltage regulators 136 in the second integrated circuit 132 may receive power from different BGA balls 94.

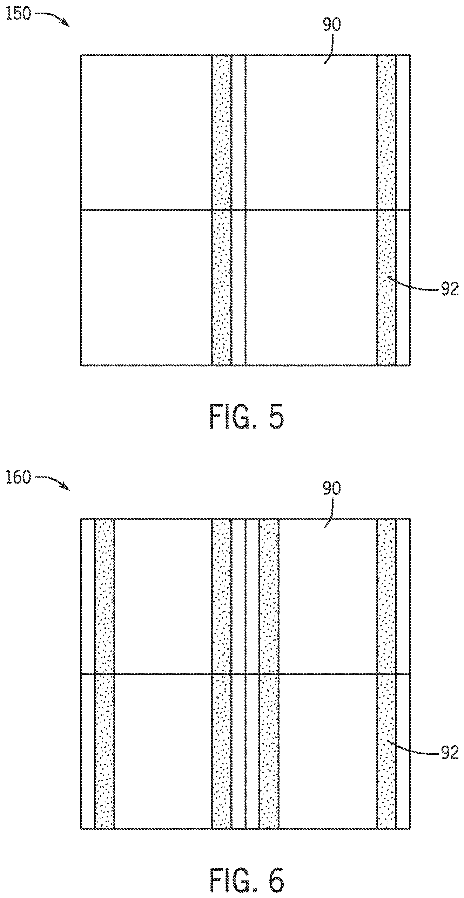

FIG. 5 is a schematic diagram of an embodiment of the integrated circuit system 12, where each sector 90 implements one voltage regulator 92. FIG. 5 illustrates the voltage regulator 92 being distributed across the sectors 90 of an integrated circuit 150. For example, each sector 90 of the integrated circuit 150 may encapsulate one voltage regulator 92 that provides power to components within the sector 90 and/or power delivery circuitry within the sector 90. As illustrated, the voltage regulator 92 may be positioned along a right edge of the sector 90 and in a vertical direction. In another example, the voltage regulator 92 may be positioned along a left edge of the sector 90, in a horizontal direction, along a top edge of the sector 90, along a bottom edge of the sector 90, and so on. That is, the voltage regulator 92 may be positioned in any suitable position within the sector 90. In the illustrated example, the integrated circuit 150 includes one column of voltage regulators 92 positioned along one side (e.g., side) of the sectors 90.

As discussed herein, the voltage regulators 92 may include fully integrated voltage regulators (FIVR), capacitor-coupled voltage regulators (C2VR), or any combination thereof. For example, a first column of voltage regulators 92 may include FIVRs and a second column of voltage regulators 92 may include C2VRs. In another example, the first column of voltage regulators 92 and the second column of voltage regulators 92 may include only FIVRs or only C2VRs. In another example, the first column of voltage regulators 92 may include FIVRs. As such, the integrated circuit 150 may include any suitable combination of fully integrated voltage regulators (FIVR) and/or capacitor-coupled voltage regulators (C2VR).

FIG. 6 is a schematic diagram of an embodiment of the integrated circuit system 12, where each sector 90 implements two voltage regulators 92. FIG. 6 illustrates the voltage regulator 92 being distributed across the sectors 90 of an integrated circuit 160 (e.g., the integrated circuit 80 described with respect to FIG. 3, the first integrated circuit 130 described with respect to FIG. 4, the second integrated circuit 132 described with respect to FIG. 4). In the illustrated example, the integrated circuit 160 includes two columns of voltage regulators 92 positioned along on both edges (e.g., sides) of the sector 90. By positioning the voltage regulators at both edges of the sector 90, a distance between the voltage regulator 92 and each component within the sector 90 may be decreased in comparison to positioning the voltage regulator at on edge of the sector 90. By decreasing the distance, power delivery may be improved, and power loss may be reduced. Additionally or alternatively, the voltage regulators 92 may be positioned in the middle of the sector 90 (e.g., along a central axis of the sector 90, closer to a central axis of the sector 90 than an outer edge). It should be noted that the voltage regulators 92 may be positioned in any suitable position within the sector 90.

Although the illustrated example of FIG. 6 includes two columns of voltage regulators 92, it may be understood that any suitable number of columns of voltage regulators may be positioned within the integrated circuit. For example, the sector 90 may include a first voltage regulator 92 positioned proximate a first edge of the sector 90, a second voltage regulator 92 positioned proximate a second edge of the sector 90, and a third voltage regulator 92 positioned between the first voltage regulator 92 and the second voltage regulator 92. As the number of columns of voltage regulators increase, a distance between the voltage regulator and components within a sector may decrease, which may improve power delivery.

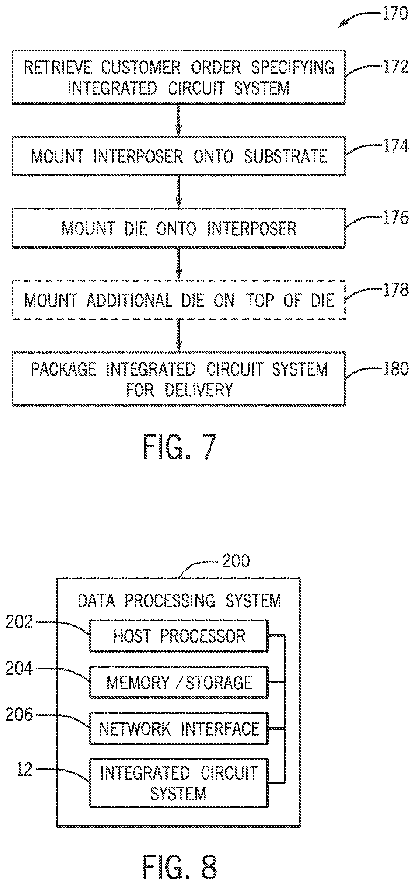

FIG. 7 is a flowchart of a method 170 for manufacturing the integrated circuit system 12 of FIG. 1. For example, a manufacturer may receive a customer order specifying the integrated circuit system 12 (block 172). The order may include a design for the integrated circuit system 12, including a number of integrated circuits, a number of voltage regulators within each sector of the integrated circuit, a power level of each sector, a voltage domain for each sector, a design to be implemented on the integrated circuit, and so on.

Based on the order, the manufacturer may mount an interposer 82 onto a package substrate 98 (block 174). The package substrate 98 may couple to a PCB board via BGA balls 94, and the interposer 82 may couple to the package substrate 98 via PSBs 100.

The manufacturer may mount an integrated circuit (e.g., the integrated circuit 80 described with respect to FIG. 3, the first integrated circuit 130 described with respect to FIG. 4, the second integrated circuit 132 described with respect to FIG. 4, the integrated circuit 150 described with respect to FIG. 5) may be mounted onto the interposer 82 (block 176) via microbumps 96. The integrated circuit may include at least one voltage regulator 92 within each sector 90 of the integrated circuit. The at least one voltage regulator 92 may include an input pathway 102 that couples to a microbump 96 to receive power and an output pathway 104 that delivers power to a respective sector 90. As such, the voltage regulator 92 may provide power directly to the respective sector 90.

For example, the order may specify two or more integrated circuits. For example, the integrated circuit system 12 may be a multi-die package (e.g., the first integrated circuit 130 and the second integrated circuit 132), then the manufacturer may mount a second integrated circuit 132 to the first integrated circuit 130 (block 178). The second integrated circuit 132 may include at least one voltage regulator 136 within each sector 141 of the second integrated circuit 132. The voltage regulators 136 of the second integrated circuit 132 may couple to voltage regulators 134 of the first integrated circuit 130 to receive power. For example, the first integrated circuit 130 may include TSVs 142 within the frontside metal layers 84 to provide a power pathway between the voltage regulators 136 of the second integrated circuit 132 and the voltage regulators 134 of the first integrated circuit 130. Based on the order, the manufacturer may mount one or more integrated circuits on the interposer 82 in a 2.5D form. The manufacturer may add any suitable number of integrated circuits to the integrated circuit system 12 based on the order.

The integrated circuit system 12 may be packed for delivery (block 180). This may provide a scalable and cost-efficient power dissipation across a range of products.

The method 170 includes various steps represented by blocks. Although the flowchart illustrates the steps in a certain sequence, it should be understood that the steps may be performed in any suitable order and certain steps may be carried out simultaneously, where appropriate. Further, certain steps or portions of the method 170 may be performed by separate systems or devices.

The processes discussed above may be carried out on the integrated circuit system 12, which may be a component included in a data processing system, such as a data processing system 200, shown in FIG. 8. The data processing system 200 may include the integrated circuit system 12 (e.g., a programmable logic device), a host processor 202, memory and/or storage circuitry 204, and a network interface 206. The data processing system 200 may include more or fewer components (e.g., electronic display, user interface structures, application specific integrated circuits (ASICs)). The host processor 202 may include any of the foregoing processors that may manage a data processing request for the data processing system 200 (e.g., to perform elaboration and simulation, to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 204 may include random access memory (RAM), read-only memory (ROM), one or more hard drives, flash memory, or the like. The memory and/or storage circuitry 204 may hold data to be processed by the data processing system 200. In some cases, the memory and/or storage circuitry 204 may also store configuration programs (e.g., bitstreams, mapping function) for programming the integrated circuit system 12. The network interface 206 may allow the data processing system 200 to communicate with other electronic devices. The data processing system 200 may include several different packages or may be contained within a single package on a single package substrate. For example, components of the data processing system 200 may be located on several different packages at one location (e.g., a data center) or multiple locations. In another example, components of the data processing system 200 may be located in separate geographic locations or areas, such as cities, states, or countries.

The data processing system 200 may be part of a data center that processes a variety of different requests. For example, the data processing system 200 may receive a data processing request via the network interface 206 to perform encryption, decryption, machine learning, video processing, voice recognition, image recognition, data compression, database search ranking, bioinformatics, network security pattern identification, spatial navigation, digital signal processing, or other specialized tasks.

The techniques and methods described herein may be applied with other types of integrated circuit systems. For example, other integrated circuits, such as graphics cards, hard drives, or other components, may include a voltage regulator within a sector of the integrated circuit system and/or implement a backside power delivery technique described herein. As such, the integrated circuit systems may enable scalable and cost-efficient power dissipation across a range of products.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 88 U.S.C. 112(f). However, for any claims containing elements designated in any other manner, it is intended that such elements are not to be interpreted under 88 U.S.C. 112(f).

### EXAMPLE EMBODIMENTS

**EXAMPLE EMBODIMENT** 1. An integrated circuit including a plurality of sectors of programmable logic circuitry, and a first voltage regulator to provide power directly to a first sector of the plurality of sectors, wherein the first voltage regulator includes an input to receive power from a microbump, and an output to provide the power to the first sector of the plurality of sectors.

**EXAMPLE EMBODIMENT 2.** The integrated circuit of example embodiment 1, wherein the plurality of sectors of programmable logic circuitry includes a first set of layers including routing circuitry for signal transfer, and a second set of layers including power delivery circuitry to provide power to a respective sector of the plurality of sectors.

**EXAMPLE EMBODIMENT 3.** The integrated circuit of example embodiment 2, wherein the first set of layers includes through silicon vias (TSVs) to provide power to another voltage regulator of another integrated circuit coupled to the integrated circuit in a stacked configuration.

**EXAMPLE EMBODIMENT 4.** The integrated circuit of example embodiment 2 or 3, wherein the power delivery circuitry is to receive power from the voltage regulator.

**EXAMPLE EMBODIMENT 5.** The integrated circuit of one of example embodiments 2 to 4 , wherein the sector of the plurality of sectors is located partially on the first set of layers and partially on the second set of layers.

**EXAMPLE EMBODIMENT 6.** The integrated circuit of one of example embodiments 1 to 5, wherein the voltage regulator is positioned within the sector of the plurality of sectors.

**EXAMPLE EMBODIMENT 7.** The integrated circuit of example embodiment 5 or 6, wherein the voltage regulator is positioned along a first edge of the sector of the plurality of sectors, and wherein the sector of the plurality of sectors includes a second voltage regulator positioned along a second edge of the sector of the plurality of sectors opposite the first edge.

**EXAMPLE EMBODIMENT 8.** An integrated circuit, including a first set of metal layers, a second set of metal layers, a plurality of separately programmable sectors of programmable logic circuitry positioned between the first set of metal layers and the second set of metal layers, and at least one voltage regulator positioned within a sector of the plurality of sectors, wherein the at least one voltage regulator is to provide power to the sector of the plurality of sectors.

**EXAMPLE EMBODIMENT 9.** The integrated circuit of example embodiment 8, wherein the at least one voltage regulator couples to a microbump of the integrated circuit to receive power from a power source.

**EXAMPLE EMBODIMENT 10.** The integrated circuit of example embodiment 8 or 9, wherein the second set of metal layers includes a pathway for power output to components within the sector of the plurality of sectors, and wherein the at least one voltage regulator is to couple to the pathway to provide the power to the components.

**EXAMPLE EMBODIMENT 11.** The integrated circuit of one of example embodiments 8 to 10, wherein the at least one voltage regulator includes two voltage regulators.

**EXAMPLE EMBODIMENT 12.** A multi-die package, including a substrate to provide power from an off-package power source, a first integrated circuit mounted on the substrate, wherein the first integrated circuit includes a first plurality of sectors, and a first voltage regulator positioned within a sector of the plurality of sectors, wherien the first voltage regulator is to provide the power to the first sector, and a second integrated circuit mounted on the first integrated circuit, wherein the second integrated circuit includes a second voltage regulator to receive power from the first integrated circuit.

**EXAMPLE EMBODIMENT 13.** The multi-die package of example embodiment 12, wherein the first voltage regulator is to provide power at a first voltage level and the second voltage regulator is to provide power at a second voltage level, wherein the first voltage level and the second voltage level are different.

**EXAMPLE EMBODIMENT 14.** The multi-die package of example embodiment 12 or 13, wherein the first voltage regulator is to provide power at a first voltage level and the second voltage regulator is to provide power at a second voltage level, wherein the first voltage level and the second voltage level are the same.

**EXAMPLE EMBODIMENT 15.** The multi-die package of one of example embodiments 12 to 14, wherein the first integrated circuit includes a first set of metal layers for signal transfer within the first integrated circuit, and a second set of metal layers for power delivery within the first integrated circuit.

**EXAMPLE EMBODIMENT 16.** The multi-die package of example embodiment 15, wherein the first set of metal layers includes through silicon vias (TSVs) to couple the second voltage regulator of the second integrated circuit to the off-package power source.

**EXAMPLE EMBODIMENT 17.** The multi-die package of example embodiment 16, wherein the first voltage regulator includes a fully integrated voltage regulator and the second voltage regulator includes a capacitive-coupled voltage regulator.

**EXAMPLE EMBODIMENT 18.** The multi-die package of one of example embodiments 15 to 17, wherein the first voltage regulator is to provide power to the second set of metal layers.

**EXAMPLE EMBODIMENT 19.** The multi-die package of one of example embodiments 12 to 18, including a hardened processor coupled to the second integrated circuit.

**EXAMPLE EMBODIMENT 20.** The multi-die package of example embodiment 19, wherein the second voltage regulator is to provide power to the hardened processor.

## Claims

1. An integrated circuit, comprising:
a plurality of sectors of programmable logic circuitry; and
a first voltage regulator to provide power directly to a first sector of the plurality of sectors, wherein the first voltage regulator comprises:
an input to receive power from a microbump; and
an output to provide the power to the first sector of the plurality of sectors.

2. The integrated circuit of claim 1, wherein the plurality of sectors of programmable logic circuitry comprises:
a first set of layers comprising routing circuitry for signal transfer; and
a second set of layers comprising power delivery circuitry to provide power to a respective sector of the plurality of sectors.

3. The integrated circuit of claim 2, wherein the first set of layers comprises through silicon vias (TSVs) to provide power to another voltage regulator of another integrated circuit coupled to the integrated circuit in a stacked configuration.

4. The integrated circuit of claim 2 or 3, wherein the power delivery circuitry is to receive power from the voltage regulator.

5. The integrated circuit of one of claims 2 to 4, wherein the sector of the plurality of sectors is located partially on the first set of layers and partially on the second set of layers.

6. The integrated circuit of one of claims 1 to 5, wherein the voltage regulator is positioned within the sector of the plurality of sectors.

7. The integrated circuit of claim 5, wherein the voltage regulator is positioned along a first edge of the sector of the plurality of sectors, and wherein the sector of the plurality of sectors comprises a second voltage regulator positioned along a second edge of the sector of the plurality of sectors opposite the first edge.

8. A multi-die package, comprising:
a substrate to provide power from an off-package power source;
a first integrated circuit mounted on the substrate, wherein the first integrated circuit comprises:
a first plurality of sectors; and
a first voltage regulator positioned within a sector of the plurality of sectors, wheren the first voltage regulator is to provide the power to the first sector; and
a second integrated circuit mounted on the first integrated circuit, wherein the second integrated circuit comprises a second voltage regulator to receive power from the first integrated circuit.

9. The multi-die package of claim 8, wherein the first voltage regulator is to provide power at a first voltage level and the second voltage regulator is to provide power at a second voltage level, wherein the first voltage level and the second voltage level are different.

10. The multi-die package of claim 8 or 9, wherein the first voltage regulator is to provide power at a first voltage level and the second voltage regulator is to provide power at a second voltage level, wherein the first voltage level and the second voltage level are the same.

11. The multi-die package of one of claims 8 to 10, wherein the first integrated circuit comprises:
a first set of metal layers for signal transfer within the first integrated circuit; and
a second set of metal layers for power delivery within the first integrated circuit.

12. The multi-die package of claim 11, wherein the first set of metal layers comprises through silicon vias (TSVs) to couple the second voltage regulator of the second integrated circuit to the off-package power source.

13. The multi-die package of claim 12, wherein the first voltage regulator comprises a fully integrated voltage regulator and the second voltage regulator comprises a capacitive-coupled voltage regulator.

14. The multi-die package of one of example embodiments 11 to 13, wherein the first voltage regulator is to provide power to the second set of metal layers.

15. The multi-die package of one of claims 8 to 14, comprising a hardened processor coupled to the second integrated circuit, and wherein the second voltage regulator is preferably configured to provide power to the hardened processor.
